# EUROPEAN PATENT SPECIFICATION

(11) **EP 3 029 834 B1**
(45) Date of publication and mention of the grant of the patent: **30.09.2020**
(21) Application number: 14275250.0
(22) Date of filing: 03.12.2014
(51) Int. Cl.: H03K 17/567, H03K 17/12, H03K 17/722, H02J 3/36

(54) **Semiconductor switching circuit**
Halbleiterschaltkreis
Dispositif de commutation à semi-conducteur

(43) Date of publication of application: 08.06.2016
(73) Proprietor: General Electric Technology GmbH, 5400 Baden (CH)
(72) Inventor: DAVIDSON, Colin Charnock, Radford Rise Stafford ST17 4PS (GB); VERSHININ, Konstantin, Wigston LE18 1FF (GB); EFIKA, Ikenna Bruce, Stafford ST16 3QE (GB)
(74) Representative: Openshaw & Co.

(56) References cited:
- US-A- 5 463 344
- US-A1- 2003 016 073
- US-A1- 2014 185 346
- US-B1- 6 239 988

## Description

This invention relates to a semiconductor switching circuit and a semiconductor switching string, each of which is for use in a high voltage direct current (HVDC) power converter.

In power transmission networks alternating current (AC) power is typically converted to direct current (DC) power for transmission via overhead lines and/or under-sea cables. This conversion removes the need to compensate for the AC capacitive load effects imposed by the transmission line or cable and reduces the cost per kilometre of the lines and/or cables, and thus becomes cost-effective when power needs to be transmitted over a long distance.

HVDC power converters are used to convert AC power to DC power. Semiconductor switching elements, such as thyristors, are a key component of HVDC power converters, and act as controlled rectifiers to convert AC power to DC power and vice versa.

US 5,463,344 A discloses methods and circuits for decreasing the turn-on time in switches having silicon controlled rectifiers through the use of MOS controlled thyristors.

US 2003/016073 A1 discloses a semiconductor high voltage switching system and a method for transmitting and distributing electrical power.

US 6,239,988 B1 discloses a flyback energy storage technique to provide a current pulse for driving semiconductor switching devices.

US 2014/185346 A1 discloses a hybrid switching circuit, which includes first and second switching devices containing first and second unequal bandgap semiconductor materials respectively. These first and second switching devices can be electrically coupled as a hybrid switch, which supports parallel conduction in response to first and second control signals received at first and second control terminals of the first and second switching devices respectively.

According to a first aspect of the invention, there is provided a semiconductor switching circuit, for use in a HVDC power converter, comprising:
a main current branch including at least one main semiconductor switching element and through which current flows in a first direction when the or each main semiconductor switching element is switched on;
an auxiliary current branch connected in parallel with the main current branch, the auxiliary current branch including at least one auxiliary semiconductor switching element; and
a control unit operatively connected to the or each main semiconductor switching element to control switching of the or each main semiconductor switching element,
wherein the control unit is programmed to switch on the or each auxiliary semiconductor switching element in the auxiliary current branch before, when or after the or each main semiconductor switching element is switched on so that an alternative current path via the auxiliary current branch is selectively created so that current flowing in the first direction through the main current branch is diverted to flow through the alternative current path so that the rate of change of current flowing through the or each main semiconductor switching element is reduced immediately after the or each said main semiconductor switching element is switched on,
characterised in that:
   a gate of one or more auxiliary semiconductor switching elements is at a different potential than that of a gate of the or each main semiconductor switching element; and
   the control unit is operatively connected via a respective voltage isolation device to the or each auxiliary semiconductor switching element to control switching of the or each auxiliary semiconductor switching element;
   wherein the voltage isolation device permits triggering of the or each auxiliary semiconductor switching element by the same control unit that is used to trigger the or each main semiconductor switching element.

The inclusion of a control unit, which is programmed to create an alternative current path via the auxiliary current branch, whereby current flowing through the main current branch is diverted to flow through the alternative current path to reduce the rate of change of current flowing through the or each main semiconductor switching element, allows the current arising from external stray capacitances, e.g. within a HVDC power converter, to be diverted through the alternative current path (rather than through the main current branch and the or each main semiconductor switching element therein) where it can be safely discharged without damaging the or each main semiconductor switching element. Such a configuration therefore obviates the need for a large saturating inductor (or di/dt reactor), which would otherwise be required to compensate for the relatively low tolerance of rate of change of current that is an inherent performance limitation of some main semiconductor switching elements such as, for example, thyristors.

Moreover, having the control unit programmed to switch on the or each auxiliary semiconductor switching element before, when (i.e. at the same time as) or after the or each main semiconductor switching element is switched on desirably allows the semiconductor switching circuit of the invention to compensate for inherent limitations in the performance of the or each main semiconductor switching element when those limitations are at their most acute.

More particularly, the semiconductor switching circuit of the invention is able to reduce the rate of change of current flowing through the or each main semiconductor switching element when the or each such element is first switched on and exposed to a large change in current. In this regard the or each main semiconductor switching element is initially in a forward-blocking condition, i.e. it is initially switched off but experiencing a positive voltage. Under such conditions the or each main semiconductor switching element will allow current to flow therethrough, and hence allow current to flow in the first direction through the main current branch, following receipt of a turn-on signal, i.e. when it is switched on.

The arrangement of the auxiliary current branch may vary depending on the requirements of the semiconductor switching circuit of the invention. An arrangement of the auxiliary current branch may include a plurality of series-connected auxiliary semiconductor switching elements. Another arrangement of the auxiliary current branch may include an anode-gated auxiliary semiconductor switching element. In such arrangements, the gate of one or more auxiliary semiconductor switching elements is at a different potential than that of the gate of the or each main semiconductor switching element.

The provision of the or each voltage isolation device in the semiconductor switching circuit provides voltage isolation between the control unit and the or each auxiliary semiconductor switching element. Such voltage isolation permits triggering of the or each auxiliary semiconductor switching element by the same control unit that is used to trigger the or each main semiconductor switching element when the gate of one or more auxiliary semiconductor switching elements is not at the same potential as the gate of the or each main semiconductor switching element. This in turn increases the number of viable arrangements of the auxiliary current branch in which the control unit is able to control switching of the or each auxiliary semiconductor switching element to reliably create the alternative current path.

In contrast omission of the or each voltage isolation device from the semiconductor switching circuit would prevent one or more auxiliary semiconductor switching elements from being triggered by the same control unit that is used to trigger the or each main semiconductor switching element.

The type of auxiliary semiconductor switching element used in the auxiliary current branch may vary depending on the requirements of the semiconductor switching circuit.

The or each auxiliary semiconductor switching element may be or may include a silicon switching element.

The or each auxiliary semiconductor switching element may be or may include a silicon carbide switching element, a gallium nitride switching element, a diamond switching element, or a switching element made of wide band gap material. A wide band gap material is a material with an energy band gap of 2eV and above.

The or each auxiliary semiconductor switching element may be or may include a thyristor.

Thyristors typically have excellent voltage and current performance characteristics, and so they are again well-suited to allowing the semiconductor switching circuit of the invention to compensate for various performance shortfalls of a main semiconductor switching element when it is operating in a forward-biased condition.

In this regard thyristors typically can be optimised either for low conduction losses or high switching speed, but generally not both. As such the thyristor included in the or each auxiliary semiconductor switching element can be optimised for high switching speeds, while the or each main semiconductor switching element may include a thyristor that is selected according to its low conduction losses, so as to permit the optimisation of both such thyristors.

The or each voltage isolation device may be arranged in various ways to interconnect the control unit and the or each auxiliary semiconductor switching element in order to enable the control unit to control switching of the or each auxiliary semiconductor switching element.

The semiconductor switching circuit may further include an or a respective auxiliary gate drive circuit arranged to interconnect the voltage isolation device and a gate of the or each auxiliary semiconductor switching element. The or each auxiliary gate drive circuit may be further connected to a cathode of the corresponding auxiliary semiconductor switching element. The or each auxiliary gate drive circuit may be configured to selectively inject current into the gate of the corresponding auxiliary semiconductor switching element.

The arrangement of the or each auxiliary gate drive circuit in this manner permits the control unit to control switching of a plurality of series-connected auxiliary semiconductor switching elements.

The semiconductor switching circuit may further include an or a respective auxiliary gate drive circuit arranged to interconnect the voltage isolation device and a gate of the or each auxiliary semiconductor switching element. The or each auxiliary gate drive circuit may be further connected to an anode of the corresponding auxiliary semiconductor switching element. The or each auxiliary gate drive circuit may be configured to selectively extract current from the gate of the corresponding auxiliary semiconductor switching element.

The arrangement of the or each auxiliary gate drive circuit in this manner permits the control unit to control switching of an anode-gated auxiliary semiconductor switching element.

The control unit may be operatively connected via a single voltage isolation device to each of a plurality of auxiliary semiconductor switching elements to control switching of each of the plurality of auxiliary semiconductor switching elements. Using a single voltage isolation device to connect the control unit to each of the plurality of auxiliary semiconductor switching elements results in a smaller and lighter semiconductor switching circuit when compared to a semiconductor switching circuit in which the control unit is connected to each auxiliary semiconductor switching element via a respective voltage isolation device.

The or each voltage isolation device may be or may include a transformer, such as a pulse transformer.

The or each auxiliary semiconductor switching element and the or each voltage isolation device may be formed on a printed circuit board. Optionally the voltage isolation device may be formed as a planar voltage isolation device on the printed circuit board. The provision of the printed circuit board as a substrate for the semiconductor switching circuit results in a more compact semiconductor switching circuit.

The control unit may be programmed to selectively switch off the or each auxiliary semiconductor switching element when the current flowing through the or each auxiliary semiconductor switching element is equal to or lower than a safety current threshold. This provides a safe and reliable means of turning off the or each auxiliary semiconductor switching element, which may be required to control the amount of current diverted to flow through the alternative current path. Such control is desirable so as not to create a further problem while attempting to alleviate the difficulties associated with the inherent performance limitations of the or each main semiconductor switching element.

The voltage rating of the main current branch may be lower than the voltage rating of the auxiliary current branch. Setting the respective voltage ratings of the main and auxiliary current branches in this manner ensures that, in the event of an overvoltage, the or each main semiconductor switching element would fail instead of the or each auxiliary semiconductor switching element, which is important for safety reasons. This is because, whilst the main current branch can be configured to be capable of safely carrying high levels of the load current (which can be in the region of several thousand amperes) even when the or each main semiconductor switching element has failed, failure of the or each auxiliary semiconductor switching element is undesirable when the auxiliary current branch is preferably formed by small-gauge wiring and PCB tracks which are not capable of carrying such levels of current.

The auxiliary current branch may include a current limiting element connected in series with the or each auxiliary semiconductor switching element. Such a current limiting element facilitates, for example, the discharge of the current arising from any external stray capacitances.

The auxiliary current branch may include a current flow check element arranged to restrict the flow of current through the alternative current path to a single direction and to be in the same direction as through the or each auxiliary semiconductor switching element. This protects the or each auxiliary semiconductor switching element from reverse voltages while the or each main semiconductor switching element is reverse-biased.

The main current branch may include a single main semiconductor switching element having first and second connection terminals and the auxiliary current branch is connected between the first and second connection terminals whereby the main and auxiliary current branches together define a semiconductor switching assembly.

Such an arrangement allows the or each auxiliary semiconductor switching element in the auxiliary current branch to share any voltage grading circuitry associated with the single main semiconductor switching element, and/or share a power supply with the single main semiconductor switching element.

The auxiliary current branch may include a single auxiliary semiconductor switching element.

The auxiliary current branch may include a plurality of series-connected auxiliary semiconductor switching elements.

The foregoing arrangements permit a tailoring of the configuration of the auxiliary current branch according to the performance rating of available auxiliary semiconductor switching elements.

The main current branch may include a main string of series-connected main semiconductor switching elements. The main string may have an upstream connection terminal at an upstream end thereof and a downstream connection terminal at a downstream end thereof. The auxiliary current branch may be connected between the upstream and downstream connection terminals of the main string. The auxiliary current branch may include an auxiliary string of series-connected auxiliary semiconductor switching elements.

Main and auxiliary current branches configured in such a manner provides considerable flexibility in tailoring the voltage ratings of the auxiliary semiconductor switching elements to the voltage ratings of the main semiconductor switching elements, e.g. an auxiliary string including four 12kV auxiliary semiconductor switching elements, i.e. a total voltage rating of 48kV, could be connected in parallel with a main string including six 8kV main semiconductor switching elements, i.e. an identical total voltage rating of 48kV.

Such a configuration is also potentially more compact than existing semiconductor switching circuit topologies.

According to a second aspect of the invention there is provided a semiconductor switching string, for use in a HVDC power converter, comprising a plurality of series-connected semiconductor switching assemblies as described hereinabove.

Such a semiconductor switching string desirably supports the switching of a larger voltage than is possible by a single such semiconductor switching assembly.

Preferred embodiments of the invention will now be described, by way of non-limiting examples, with reference to the accompanying drawings in which:
Figure 1 shows a schematic view of a semiconductor switching circuit according to a first embodiment of the invention;
Figures 2a and 2b shows schematic views of auxiliary gate drive circuits which form part of the semiconductor switching circuit of Figure 1;
Figure 3 illustrates schematically the flow of a stray capacitance discharge current through the semiconductor switching circuit shown in Figure 1;
Figure 4 illustrates the reduction in the rate of change of current flowing through a main semiconductor switching element which forms part of the semiconductor switching circuit shown in Figure 1;
Figure 5 shows a schematic view of a semiconductor switching circuit according to a second embodiment of the invention; and
Figure 6 shows a schematic view of a semiconductor switching circuit according to a third embodiment of the invention.

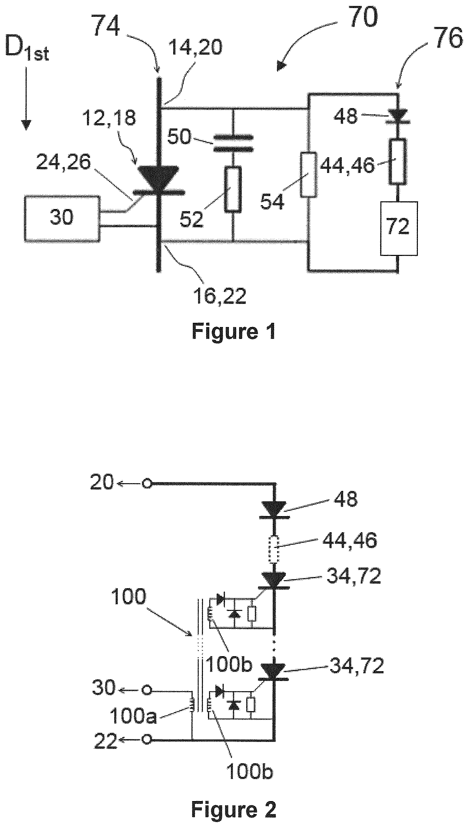

A semiconductor switching circuit according to a first embodiment of the invention is shown in Figure 1, and is designated generally by reference numeral 70.

The first semiconductor switching circuit 70 has a main current branch 74 which includes a single main semiconductor switching element 12 that has first and second connection terminals 14, 16. In the embodiment shown the main semiconductor switching element 12 is a main thyristor 18. Preferably the main semiconductor switching element 12 is optimised for lowest conduction (on-state) losses at the expense of other parameters such as turn-on di/dt capability, turn-off characteristics and off-state dv/dt capability.

The main thyristor 18 shown includes an anode 20 which defines the first connection terminal 14, a cathode 22 which defines the second connection terminal 16, and a gate 24 that defines a control terminal 26 via which the main thyristor 18 may be switched on.

The semiconductor switching circuit further includes a control unit 30. The control unit 30 is connected to the cathode 22 and gate 24 of the main thyristor 18 to enable it to switch on the main thyristor 18.

When the main thyristor 18 is so switched on, current flows through the main current branch 74, i.e. through the main thyristor 18, in a first direction D₁ₛₜ from the first connection terminal 14 to the second connection terminal 16, i.e. from the anode 20 to the cathode 22.

The main thyristor 18 is, however, a naturally commutated switching element which means that, while it can be switched on via its control terminal 26, it is turned off by arranging for the circuit in which it is located to force the current flowing through it to fall to zero and then maintaining a period, typically some few hundred microseconds, during which the main thyristor 18 is reverse-biased, i.e. a negative voltage is applied between its first and second terminals 14, 16. This is in contrast to some thyristor derivatives such as the gate turn-off thyristor (GTO) and integrated gate commutated thyristor (IGCT) that are self-commutated whereby they can be both switched on and switched off via their gates.

The first semiconductor switching circuit 70 also includes an auxiliary current branch 76 which is connected between the first and second connection terminals 14, 16 so as to lie in parallel with the main current branch 74. In this manner the main and auxiliary current branches 74,76 together define a semiconductor switching assembly.

The auxiliary current branch 76 includes a plurality of series-connected auxiliary semiconductor switching elements 72 which is electrically connected between the first and second connection terminals 14, 16 of the main thyristor 18. In the embodiment shown each auxiliary semiconductor switching element 72 includes an auxiliary silicon pulse-power thyristor 34 which has an anode 36 connected towards the first connection terminal 14, a cathode 38 connected to or towards the second connection terminal 16, and a gate 40 that defines a control terminal 126 via which the auxiliary silicon pulse-power thyristor 34 may be switched on. The use of a plurality of series-connected auxiliary silicon pulse-power thyristors 34 enables the voltage rating of the auxiliary current branch 76 to match the voltage rating of the main thyristor 18.

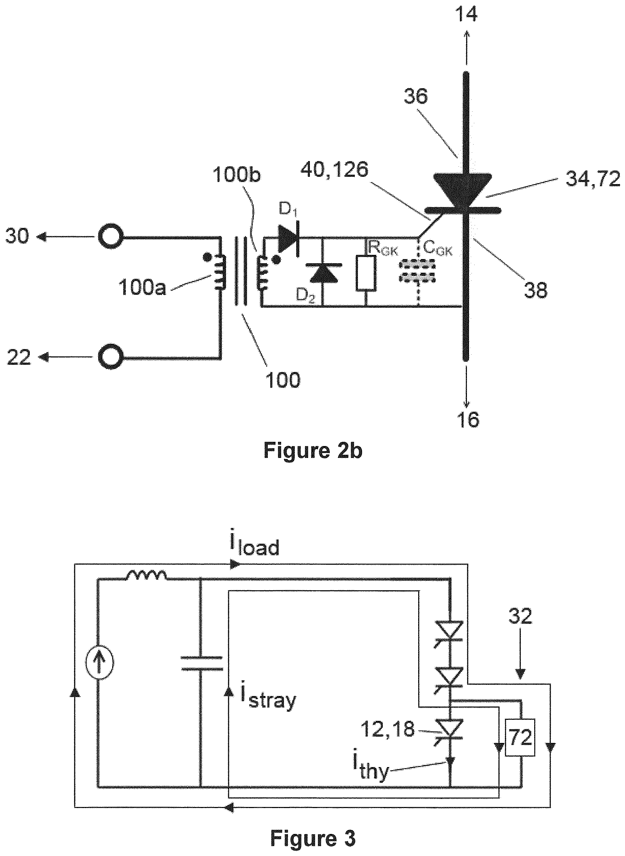

The control unit 30 is also operatively connected via a pulse transformer 100 to the gate 40 of each auxiliary semiconductor switching element 72 to enable it to switch on each auxiliary semiconductor switching element 72, as shown in Figures 2a and 2b.

The pulse transformer 100 includes a first winding 100a and a plurality of second windings 100b. The first winding 100a is mutually coupled with each of the second windings 100b, and the control unit 30 is connected to the first winding 100a.

The first semiconductor switching circuit 70 further includes a plurality of auxiliary gate drive circuits, each of which is arranged to interconnect a respective second winding 100b and the gate 40 of a respective auxiliary semiconductor switching element 72. In each auxiliary gate drive circuit, a first diode D₁ is connected in series with the corresponding second winding 100b between the cathode 38 and gate 40 of the corresponding auxiliary semiconductor switching element 72, and a second diode D₂ is connected in parallel with the series-connection of the first diode D₁ and secondary winding 100b.

A resistor R_{GK} and a capacitor C_{GK} is each connected in parallel with the second diode D₂. The resistor R_{GK} further de-sensitises the gate 40 of the auxiliary semiconductor switching element 72 and reduce the probability that spurious interference or dv/dt could cause the auxiliary semiconductor switching element 72 to turn-on at an unintended time. The capacitor C_{GK} further improves immunity to very high-frequency interference pulses.

The first and second diodes D₁ and D₂ are included in each auxiliary gate drive circuit to prevent application of reverse current and reverse voltage respectively to the gate 40 of the corresponding auxiliary semiconductor switching element 72. Reverse current into the gate 40 of the auxiliary semiconductor switching element 72 may cause it to turn partially off, which can be destructive for the auxiliary semiconductor switching element 72 if it happens when the anode-cathode current is high.

The configuration of each auxiliary gate drive circuit in the above manner permits injection of current into the gate 40 of the corresponding auxiliary semiconductor switching element 72 when the control unit 30 generates a positive voltage pulse to the first winding 100a of the pulse transformer 100 to switch on the corresponding auxiliary semiconductor switching element 72.

The control unit 30 is programmed to switch on the auxiliary semiconductor switching element 72 to selectively create an alternative current path 32 via the auxiliary current branch 76, i.e. between the first and second connection terminals 14, 16.

More particularly the plurality of series-connected auxiliary semiconductor switching elements 72 is connected in parallel with the main semiconductor switching element 12, i.e. the main thyristor 18, such that when the auxiliary semiconductor switching element 72 is switched on the resulting alternative current path 32 allows current to flow via the auxiliary current branch 76 in the first direction D₁ₛₜ from the first connection terminal 14 to the second connection terminal 16 of the main thyristor 18.

The auxiliary current branch 76 shown in Figure 1 also includes an optional current limiting element 44, in the form of a resistor 46, which is connected in series with the plurality of series-connected auxiliary semiconductor switching elements 72.

The auxiliary current branch 76 also additionally includes a further, series-connected diode 48 which is arranged to restrict the flow of current through the alternative current path 32 in a single direction and to be in the same direction as through each auxiliary silicon pulse-power thyristor 34, i.e. in the first direction D₁ₛₜ. The further, series-connected diode 48 is included to protect the auxiliary silicon pulse-power thyristors 34 from reverse voltages while the main thyristor 18 is reverse-biased. The reverse voltage capability of the further, series-connected diode 48 is set to be above the reverse voltage capability of the main thyristor 18.

In other embodiments of the invention, the further, series-connected diode 48 may be replaced by a plurality of further, series-connected diodes.

As well as having the auxiliary current branch 76 connected in parallel therewith, the main current branch 74, i.e. the main thyristor 18, may also have a damping circuit (which includes a damping capacitor 50 and a damping resistor 52), as well as a further resistor 54, connected in parallel therewith.

The pulse current rating of each auxiliary silicon pulse-power thyristor 34 in the auxiliary semiconductor switching element 72 of the first semiconductor switching circuit 70 is sufficiently high, e.g. a few hundred amps, and so the control unit 30 is programmed to switch on the auxiliary semiconductor switching elements 72 as the main thyristor 18 is switched on.

More particularly, the control unit 30 is programmed to switch on each auxiliary silicon pulse-power thyristor 34 in the auxiliary semiconductor switching element 72 in response to generation of a turn-on signal for the main thyristor 18, such that each auxiliary silicon pulse-power thyristor 34 is switched on about 10 to 20 µs before the main thyristor 18 is switched on, i.e. just before the main thyristor 18 is switched on. This causes any stray capacitance discharge current i_{stray} arising from a stray capacitance, e.g. within a larger circuit in which the first semiconductor switching circuit 70 is incorporated (e.g. as shown in Figure 3), to be diverted to flow through the alternative current path 32 created by switching on the auxiliary semiconductor switching elements 72 in the auxiliary current branch 76. Such diverted stray capacitance discharge current i_{stray} is then largely or completely discharged.

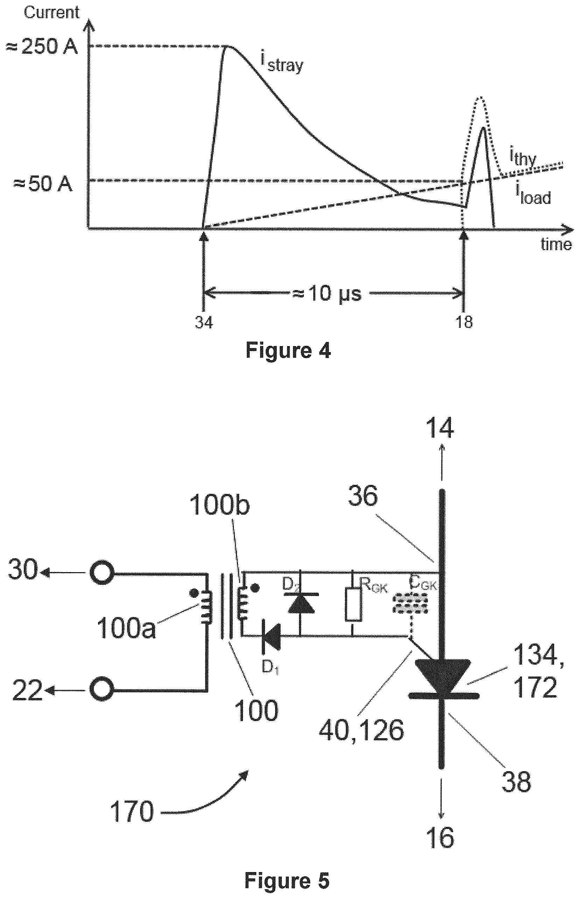

Such discharging of the stray capacitance discharge current i_{stray} as the main thyristor 18 is switched on reduces the rate of change of current i_{thy} which flows through the main thyristor 18 when it conducts current, i.e. immediately after the main thyristor 18 receives a turn-on signal and is switched on, as shown schematically in Figure 4.

Such a reduction in the rate of change of current experienced by the main thyristor 18 as it is switched on means that a much smaller saturating inductor can be used in conjunction with the main thyristor 18 than would otherwise be the case.

There is a trade-off between selecting the value of the current limiting resistor 46 and choosing the time delay before the main thyristor 18 is switched on: a low value of current limiting resistor 46 allows the time delay to be short, and hence the load current i_{load} (which typically is rising at about 5A/µs) will not have risen too much by the time the main thyristor 18 is fully turned on. However, a low value of current limiting resistor 46 requires a higher peak current rating for each auxiliary silicon pulse-power thyristor 34.

In other embodiments of the invention the control unit 30 may be similarly configured to switch on the auxiliary silicon pulse-power thyristor 34 in each auxiliary semiconductor switching element 72 in response to generation of a turn-on signal for the main thyristor 18, but such that the auxiliary silicon pulse-power thyristor 34 is switched on at the same time as or shortly after the main thyristor 18 is switched on.

In any event, in the embodiments shown, once the stray capacitance discharge current i_{stray} has been suitably discharged, each auxiliary semiconductor switching element 72 is switched off and the alternative current path 32 closed. In other embodiments, however, the auxiliary semiconductor switching elements 72 may be left simply to turn off naturally.

The provision of the pulse transformer 100 in the first semiconductor switching circuit 70 provides voltage isolation between the control unit 30 and each auxiliary semiconductor switching element 72. Such voltage isolation permits triggering of each auxiliary semiconductor switching element 72 by the same control unit 30 that is used to trigger the main thyristor 18 when the gate 40 of one or more of the auxiliary semiconductor switching elements 72 is not at the same potential as the gate 24 of the main thyristor, as is the case with the first semiconductor switching circuit 70 due to the series-connection of the plurality of auxiliary semiconductor switching elements 72.

In contrast omission of the pulse transformer 100 from the first semiconductor switching circuit 30 would prevent one or more of the auxiliary semiconductor switching elements from being triggered by the same control unit 30 that is used to trigger the main thyristor 30.

It is envisaged that, in other embodiments of the invention, the first semiconductor switching circuit 70 may include a plurality of pulse transformers. In such embodiments, each pulse transformer is used to connect the control unit 30 to a respective one of the auxiliary gate drive circuits in a one-to-one-correspondence arrangement.

A second semiconductor switching circuit according to a second embodiment of the invention is shown in Figure 5, and is designated generally by the reference numeral 170. The second semiconductor switching circuit 170 is similar in structure and operation to the first semiconductor switching circuit 70, and like features share the same reference numerals.

The second semiconductor switching circuit 170 differs from the first semiconductor switching circuit 70 in that the plurality of auxiliary silicon pulse-power thyristors 34 is replaced by a single silicon carbide thyristor 134. The high voltage rating of the silicon carbide thyristor 134 makes it possible to use a single auxiliary semiconductor switching element 172 in the auxiliary current branch 76.

It is envisaged that, in other embodiments of the invention, the silicon carbide thyristor 134 may be replaced by another thyristor made from a wide band gap material, such as gallium nitride or diamond.

Silicon carbide semiconductor devices are typically fabricated by epitaxy onto a substrate which forms one of the power terminals. At present, with silicon carbide, only n-type substrates can be made with sufficiently high conductivity for this purpose. Since a thyristor has a p-n-p-n structure, an n-type substrate needs to form the cathode of the thyristor. The gate on the other hand needs to be created on the top side of the semiconductor. If the gate of the silicon carbide thyristor were to be connected to the p-base in the same way as for a silicon thyristor, this would require the gate to be connected to the layer immediately above the n-type substrate, which is very difficult to achieve for a high voltage device. In comparison connecting the gate to the n-base, which is the second layer from the top of the substrate, results in a silicon carbide thyristor that is much easier to fabricate. For this reason, practical silicon carbide thyristors are fabricated with the gate connected to the intermediate n-layer of the structure (the n-base). This means that a gate drive circuit for a silicon carbide thyristor needs to be connected to the anode of the silicon carbide thyristor and to extract current from (rather than inject current into) the gate.

The pulse transformer 100 of the second semiconductor switching circuit 170 includes a first winding 100a and a second winding 100b. The first winding 100a is mutually coupled with the second winding 100b, and the control unit 30 is connected to the first winding 100a. The second semiconductor switching circuit 170 further includes an auxiliary gate drive circuit, each of which is arranged to interconnect the second winding 100b and the gate 40 of the silicon carbide thyristor 134.

The auxiliary gate drive circuit of the second semiconductor switching circuit 170 is similar in structure to each auxiliary gate drive circuit of the first semiconductor switching circuit 70. The auxiliary gate drive circuit of the second semiconductor switching circuit 170 differs from each auxiliary gate drive circuit of the first semiconductor switching circuit 70 in that the auxiliary gate drive circuit of the second semiconductor switching circuit 170 is connected between the anode and gate 36,126 of the auxiliary silicon carbide thyristor 134, i.e. the auxiliary semiconductor switching element 172 is anode-gated.

The configuration of the auxiliary gate drive circuit in the above manner permits extraction of current into the gate 40 of the anode-gated auxiliary semiconductor switching element 172 when the control unit 30 generates a positive voltage pulse to the first winding 100a of the pulse transformer 100 to switch on the anode-gated auxiliary semiconductor switching element 172.

The provision of the pulse transformer 100 in the second semiconductor switching circuit 170 provides voltage isolation between the control unit 30 and the anode-gated auxiliary semiconductor switching element 172. Such voltage isolation permits triggering of the anode-gated auxiliary semiconductor switching element 72 by the same control unit 30 that is used to trigger the main thyristor 18 when the gate 40 of the anode-gated auxiliary semiconductor switching element 172 is not at the same potential as the gate 24 of the main thyristor, as is the case with the second semiconductor switching circuit 170 due to the anode gating of the auxiliary semiconductor switching element 172.

In contrast omission of the pulse transformer 100 from the second semiconductor switching circuit 170 would prevent the anode-gated auxiliary semiconductor switching element 172 from being triggered by the same control unit 30 that is used to trigger the main thyristor 18.

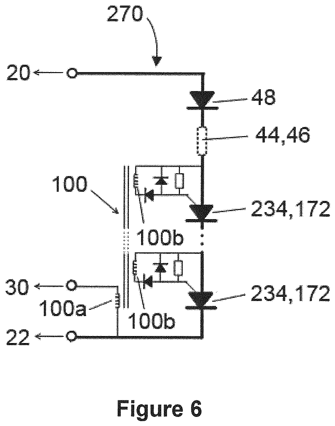

In a third embodiment of the invention, the third semiconductor switching circuit 270 may include a plurality of auxiliary silicon carbide thyristors 234, each of which is associated with a respective one of a plurality of auxiliary gate drive circuits as shown in Figure 6. In such an embodiment, the third semiconductor switching circuit 270 includes a single pulse transformer 100 to connect the control unit 30 to each auxiliary gate drive circuit, but may instead include a plurality of pulse transformers to connect the control unit 30 to a respective one of the auxiliary gate drive circuits in a one-to-one-correspondence arrangement.

The or each auxiliary semiconductor switching element 72, 172, the further, series-connected diode 48 and/or the or each pulse transformer 100 may be formed on a printed circuit board. Optionally the or each pulse transformer 100 may be formed as a planar transformer on the printed circuit board. The provision of the printed circuit board as a platform for each semiconductor switching circuit 70, 170, 270 results in a more compact semiconductor switching circuit. The use of the printed circuit board as a platform for each semiconductor switching circuit 70, 170, 270 is made possible by the low power dissipation, usually below 1 W, of the or each auxiliary semiconductor switching element 72, 172 which carries current for a relatively small proportion of the time, typically 0.1%. This is the case even when a high power main thyristor 18 requiring high-efficiency water cooling is used in the main current branch 74.

The control unit 30 may be programmed to selectively switch off the or each auxiliary semiconductor switching element 72, 172 when the current (i.e. the anode-cathode current) flowing through the or each auxiliary semiconductor switching element 72, 172 is equal to or lower than a safety current threshold. Under such circumstances the first and second diodes D₁, D₂ may be omitted from the or each auxiliary gate drive circuit.

This provides a safe and reliable means of turning off the or each auxiliary semiconductor switching element 72, 172, which may be required to control the amount of current diverted to flow through the alternative current path 32. Such control is desirable so as not to create a further problem while attempting to alleviate the difficulties associated with the inherent performance limitations of the main thyristor 18.

The voltage rating of the main current branch 74 may be lower than the voltage rating of the auxiliary current branch 76. More specifically, the voltage rating of the main thyristor 18 may be set to be lower than the voltage rating of the plurality of series-connected auxiliary semiconductor switching elements 72 of the first semiconductor switching circuit 70 or the single auxiliary semiconductor switching element 172 of the second semiconductor switching circuit 170. Setting the respective voltage ratings of the main and auxiliary current branches 74, 76 in this manner ensures that, in the event of an overvoltage, the main thyristor 18 would fail instead of the or each auxiliary semiconductor switching element 72, 172, which is important for safety reasons. This is because, whilst the main current branch 74 can be configured to be capable of safely carrying high levels of the load current (which can be in the region of several thousand amperes) even when the main thyristor 18 has failed, failure of the or each auxiliary semiconductor switching element 72, 172 is undesirable when the auxiliary current branch 76 is preferably formed by small-gauge wiring and PCB tracks which are not capable of carrying such levels of current.

A semiconductor switching string (not shown) according to a further embodiment of the invention may include a plurality of series connected semiconductor switching assemblies as described hereinabove.

## Claims

1. A semiconductor switching circuit (70, 170), for use in a HVDC power converter, comprising:
a main current branch (74) including at least one main semiconductor switching element (12) and through which current flows in a first direction (D1s1) when the or each main semiconductor switching element (12) is switched on;
an auxiliary current branch (76) connected in parallel with the main current branch (74), the auxiliary current branch (76) including at least one auxiliary semiconductor switching element (72, 172); and
a control unit (30) operatively connected to the or each main semiconductor switching element (12) to control switching of the or each main semiconductor switching element (12), wherein the control unit (30) is programmed to switch on the or each auxiliary semiconductor switching element (72, 172) in the auxiliary current branch (76) so that an alternative current path (32) via the auxiliary current branch (76) is selectively created so that current (i_{stray}) flowing in the first direction through the main current branch (74) is diverted to flow through the alternative current path (32) so that the rate of change of current (i_{stray}) flowing through the or each main semiconductor switching element (12) is reduced immediately after the or each said main semiconductor switching element (12) is switched on,
**characterised in that**:
a gate (40) of one or more auxiliary semiconductor switching elements is at a different potential than that of a gate (24) of the or each main semiconductor switching element (12); and
the control unit (30) is operatively connected via the respective voltage isolation device to the or each auxiliary semiconductor switching element (72, 172) to control switching of the or each auxiliary semiconductor switching element (72, 172),
wherein the voltage isolation device permits triggering of the or each auxiliary semiconductor switching element (72, 172) by the same control unit (30) that is used to trigger the or each main semiconductor switching element (12).

2. A semiconductor switching circuit (70) according to Claim 1 further including a respective auxiliary gate drive circuit arranged to interconnect the voltage isolation device and a gate (40) of the or each auxiliary semiconductor switching element (72), the or each auxiliary gate drive circuit being further connected to a cathode (38) of the corresponding auxiliary semiconductor switching element (72), the or each auxiliary gate drive circuit being configured to selectively inject current into the gate (40) of the corresponding auxiliary semiconductor switching element (72).

3. A semiconductor switching circuit (70) according to Claim 1 or Claim 2 wherein the or each auxiliary semiconductor switching element (72) is or includes a silicon switching element.

4. A semiconductor switching circuit (170) according to Claim 1 further including an or a respective auxiliary gate drive circuit arranged to interconnect the voltage isolation device and a gate (40) of the or each auxiliary semiconductor switching element (172), the or each auxiliary gate drive circuit being further connected to an anode (36) of the corresponding auxiliary semiconductor switching element (172), the or each auxiliary gate drive circuit being configured to selectively extract current from the gate (40) of the corresponding auxiliary semiconductor switching element (172).

5. A semiconductor switching circuit (170) according to Claim 1 or Claim 4 wherein the or each auxiliary semiconductor switching element (172) is or includes a silicon carbide switching element, a gallium nitride switching element, a diamond switching element or a switching element made of wide band gap material.

6. A semiconductor switching circuit (70, 170) according to any preceding claim wherein the or each auxiliary semiconductor switching element (72, 172) is or includes a thyristor.

7. A semiconductor switching circuit (70, 170) according to any preceding claim wherein the control unit (30) is operatively connected via a single voltage isolation device to each of a plurality of auxiliary semiconductor switching elements (72, 172) to control switching of each of the plurality of auxiliary semiconductor switching elements (72, 172).

8. A semiconductor switching circuit (70, 170) according to any preceding claim wherein the or each voltage isolation device is or includes a transformer (100).

9. A semiconductor switching circuit (70, 170) according to any preceding claim wherein the or each auxiliary semiconductor switching element (72, 172) and the or each voltage isolation device is formed on a printed circuit board, and optionally wherein the voltage isolation device is formed as a planar voltage isolation device on the printed circuit board.

10. A semiconductor switching circuit (70, 170) according to any preceding claim wherein the control unit (30) is programmed to selectively switch off the or each auxiliary semiconductor switching element (72, 172) when the current flowing through the or each auxiliary semiconductor switching element (72, 172) is equal to or lower than a safety current threshold.

11. A semiconductor switching circuit (70, 170) according to any preceding claim wherein the voltage rating of the main current branch (74) is lower than the voltage rating of the auxiliary current branch (76).

12. A semiconductor switching circuit (70, 170) according to any preceding claim wherein the main current branch (74) includes a single main semiconductor switching element (12) having first and second connection terminals (14, 16) and the auxiliary current branch (76) is connected between the first and second connection terminals (14, 16) whereby the main and auxiliary current branches (74, 76) together define a semiconductor switching assembly.

13. A semiconductor switching circuit (70, 170) according to Claim 12 wherein the auxiliary current branch (76) includes a single auxiliary semiconductor switching element (172), or wherein the auxiliary current branch (76) includes a plurality of series-connected auxiliary semiconductor switching elements (72).

14. A semiconductor switching circuit according to any of Claims 1 to 11 wherein the main current branch includes a main string of series-connected main semiconductor switching elements, the main string having an upstream connection terminal at an upstream end thereof and a downstream connection terminal at a downstream end thereof, the auxiliary current branch is connected between the upstream and downstream connection terminals of the main string, and the auxiliary current branch includes an auxiliary string of series-connected auxiliary semiconductor switching elements (72).

15. A semiconductor switching string, for use in a HVDC power converter, comprising a plurality of series-connected semiconductor switching assemblies according to Claim 12 or Claim 13.

## Patentansprüche

1. Halbleiterschaltkreis (70, 170) zur Verwendung in einem HVDC-Leistungswandler, der umfasst:
einen Hauptstromzweig (74), der mindestens ein Haupthalbleiterschaltelement (12) beinhaltet, und durch den Strom in eine erste Richtung (D₁ₛₜ) fließt, wenn das oder jedes Halbleiterschaltelement (12) eingeschaltet ist;
einen Hilfsstromzweig (76), der parallel mit dem Hauptstromzweig (74) geschaltet ist, wobei der Hilfsstromzweig (76) mindestens ein Hilfshalbleiterschaltelement (72, 172) beinhaltet; und
eine Steuereinheit (30), die betrieblich mit dem oder jedem Haupthalbleiterschaltelement (12) verbunden ist, um das Schalten des einen oder jedes Haupthalbleiterschaltelements (12) zu steuern,
wobei die Steuereinheit (30) programmiert ist, um das eine oder jedes Hilfshalbleiterschaltelement (72, 172) in dem Hilfsstromzweig (76) derart zu schalten, dass ein alternativer Stromweg (32) über den Hilfsstromzweig (76) selektiv derart angelegt wird, dass Strom (i_{stray}), der in die erste Richtung durch den Hauptstromzweig (74) fließt, umgeleitet wird, um durch den alternativen Stromweg (32) derart zu fließen, dass die Änderungsrate von Strom (i_{stray}), der durch das oder jedes Haupthalbleiterschaltelement (12) fließt, unmittelbar reduziert wird, nachdem das oder jedes Haupthalbleiterschaltelement (12) eingeschaltet wurde,
**dadurch gekennzeichnet, dass**:
ein Gate (40) eines oder mehrerer Hilfshalbleiterschaltelemente ein unterschiedliches Potenzial von dem des Gate (24) des einen oder jedes Haupthalbleiterschaltelements (12) aufweist; und
die Steuereinheit (30) betrieblich über eine jeweilige Spannungsisoliervorrichtung mit dem oder jedem Hilfshalbleiterschaltelement (72, 172) verbunden ist, um das Schalten des oder jedes Hilfshalbleiterschaltelements (72, 172) zu steuern,
wobei die Spannungsisoliervorrichtung das Auslösen des oder jedes Hilfshalbleiterschaltelements (72, 172) durch dieselbe Steuereinheit (30), die zum Auslösen des oder jedes Haupthalbleiterschaltelements (12) verwendet wird, erlaubt.

2. Halbleiterschaltkreis (70) nach Anspruch 1, der weiter eine jeweilige Hilfs-Gate-Treiberschaltung beinhaltet, die eingerichtet ist, um die Spannungsisoliervorrichtung und ein Gate (40) des oder jedes Hilfshalbleiterschaltelements (72) zu verschalten, wobei die oder jede Hilfs-Gate-Treiberschaltung weiter mit einer Kathode (38) des entsprechenden Hilfshalbleiterschaltelements (72) verbunden ist, wobei die oder jede Hilfs-Gate-Treiberschaltung konfiguriert ist, um selektiv Strom in das Gate (40) des entsprechenden Hilfshalbleiterschaltelements (72) zu injizieren.

3. Halbleiterschaltkreis (70) nach Anspruch 1 oder Anspruch 2, wobei das oder jedes Hilfshalbleiterschaltelement (72) ein Siliziumschaltelement ist oder beinhaltet.

4. Halbleiterschaltkreis (170) nach Anspruch 1, der weiter eine oder eine jeweilige Hilfs-Gate-Treiberschaltung beinhaltet, die eingerichtet ist, um die Spannungsisoliervorrichtung und ein Gate (40) des oder jedes Hilfshalbleiterschaltelements (172) zu verschalten, wobei die oder jede Hilfs-Gate-Treiberschaltung weiter mit einer Anode (36) des entsprechenden Hilfshalbleiterschaltelements (172) verbunden ist, wobei die oder jede Hilfs-Gate-Treiberschaltung konfiguriert ist, um selektiv Strom aus dem Gate (40) des entsprechenden Hilfshalbleiterschaltelements (172) zu extrahieren.

5. Halbleiterschaltkreis (170) nach Anspruch 1 oder Anspruch 4, wobei das oder jedes Hilfshalbleiterschaltelement (172) ein Siliziumkarbidschaltelement, ein Galliumnitridschaltelement, ein Diamantschaltelement oder ein Schaltelement, das aus einem Wide-Band-Gap-Material hergestellt ist, ist oder dieses beinhaltet.

6. Halbleiterschaltkreis (70, 170) nach einem vorstehenden Anspruch, wobei das oder jedes Hilfshalbleiterschaltelement (72, 122) ein Thyristor ist oder diesen beinhaltet.

7. Halbleiterschaltkreis (70, 170) nach einem vorstehenden Anspruch, wobei die Steuereinheit (30) betrieblich über eine einzige Spannungsisoliervorrichtung mit jedem einer Vielzahl von Hilfshalbleiterschaltelementen (72, 172) verbunden ist, um das Schalten jedes der Vielzahl von Hilfshalbleiterschaltelementen (72, 172) zu steuern.

8. Halbleiterschaltkreis (70, 170) nach einem vorstehenden Anspruch, wobei die oder jede Spannungsisoliervorrichtung ein Transformator (100) ist oder diesen beinhaltet.

9. Halbleiterschaltkreis (70, 170) nach einem vorstehenden Anspruch, wobei das oder jedes Hilfshalbleiterschaltelement (72, 172) und die oder jede Spannungsisoliervorrichtung auf einer Leiterplatte gebildet sind, und wobei die Spannungsisoliervorrichtung optional als eine planare Spannungsisoliervorrichtung auf der Leiterplatte gebildet ist.

10. Halbleiterschaltkreis (70, 170) nach einem vorstehenden Anspruch, wobei die Steuereinheit (30) programmiert ist, um selektiv das oder jedes Hilfshalbleiterschaltelement (72, 172) auszuschalten, wenn der Strom, der durch das oder jedes Hilfshalbleiterschaltelement (72, 172) fließt, gleich oder niedriger ist als ein Sicherheitsstromschwellenwert.

11. Halbleiterschaltkreis (70, 170) nach einem vorstehenden Anspruch, wobei die Nennspannung des Hauptstromzweigs (74) niedriger ist als die Nennspannung des Hilfsstromzweigs (76).

12. Halbleiterschaltkreis (70, 170) nach einem vorstehenden Anspruch, wobei der Hauptstromzweig (74) ein einziges Haupthalbleiterschaltelement (12) beinhaltet, das einen ersten und einen zweiten Verbindunganschluss (14, 16) aufweist, und der Hilfsstromzweig (76) zwischen dem ersten und dem zweiten Verbindunganschluss (14, 16) verbunden ist, wodurch der Haupt- und der Hilfsstromzweig (74, 76) gemeinsam eine Halbleiterschalteranordnung bilden.

13. Halbleiterschaltkreis (70, 170) nach Anspruch 12, wobei der Hilfsstromzweig (76) ein einziges Hilfshalbleiterschaltelement (172) beinhaltet, oder wobei der Hilfsstromzweig (76) eine Vielzahl seriell verschalteter Hilfshalbleiterschaltelemente (72) beinhaltet.

14. Halbleiterschaltkreis nach einem der Ansprüche 1 bis 11, wobei der Hauptstromzweig eine Hauptfolge seriell verschalteter Haupthalbleiterschaltelemente beinhaltet, wobei die Hauptfolge einen stromaufwärtigen Verbindungsanschluss an ihrem stromaufwärtigen Ende und einen stromabwärtigen Verbindungsanschluss an ihrem stromabwärtigen Ende aufweist, wobei der Hilfsstromzweig zwischen dem stromaufwärtigen und dem stromabwärtigen Verbindungsanschluss der Hauptfolge verbunden ist, und der Hilfsstromzweig eine Hilfsfolge seriell verschalteter Hilfshalbleiterschaltelemente (72) beinhaltet.

15. Halbleiterschaltfolge zur Verwendung in einem HVDC-Leistungswandler, die eine Vielzahl seriell verschalteter Halbleiterschaltanordnungen nach Anspruch 12 oder Anspruch 13 umfasst.

## Revendications

1. Circuit de commutation à semi-conducteur (70, 170), pour une utilisation dans un convertisseur de puissance HVDC, comprenant :
une branche de courant principale (74) incluant au moins un élément de commutation à semi-conducteur principal (12) et à travers laquelle un courant circule dans une première direction (D₁ₛₜ) lorsque le ou chaque élément de commutation à semi-conducteur principal (12) est activé ;
une branche de courant auxiliaire (76) connectée en parallèle avec la branche de courant principale (74), la branche de courant auxiliaire (76) incluant au moins un élément de commutation à semi-conducteur auxiliaire (72, 172) ; et
une unité de commande (30) connectée fonctionnellement au ou à chaque élément de commutation à semi-conducteur principal (12) pour commander une commutation du ou de chaque élément de commutation à semi-conducteur principal (12),
dans lequel l'unité de commande (30) est programmée pour activer le ou chaque élément de commutation à semi-conducteur auxiliaire (72, 172) dans la branche de courant auxiliaire (76) de façon à ce qu'un autre trajet de courant (32) via la branche de courant auxiliaire (76) soit créé de manière sélective de façon à ce qu'un courant (i_{stray}) circulant dans la première direction à travers la branche de courant principale (74) soit dévié pour circuler à travers l'autre trajet de courant (32) de façon à ce que le rythme de variation d'un courant (i_{stray}) circulant à travers le ou chaque élément de commutation à semi-conducteur principal (12) soit réduit juste après que le ou chaque élément de commutation à semi-conducteur principal (12) a été activé,
**caractérisé en ce que** :
une grille (40) d'un ou plusieurs éléments de commutation à semi-conducteur auxiliaires est à un potentiel différent de celui d'une grille (24) du ou de chaque élément de commutation à semi-conducteur principal (12) ; et
l'unité de commande (30) est connectée fonctionnellement via un dispositif d'isolation de tension respectif au ou à chaque élément de commutation à semi-conducteur auxiliaire (72, 172) pour commander une commutation du ou de chaque élément de commutation à semi-conducteur auxiliaire (72, 172),
dans lequel le dispositif d'isolation de tension permet un déclenchement du ou de chaque élément de commutation à semi-conducteur auxiliaire (72, 172) par la même unité de commande (30) qui est utilisée pour déclencher le ou chaque élément de commutation à semi-conducteur principal (12).

2. Circuit de commutation à semi-conducteur (70) selon la revendication 1 incluant en outre un circuit d'attaque de grille auxiliaire respectif agencé pour interconnecter le dispositif d'isolation de tension et une grille (40) du ou de chaque élément de commutation à semi-conducteur auxiliaire (72), le ou chaque circuit d'attaque de grille auxiliaire étant en outre connecté à une cathode (38) de l'élément de commutation à semi-conducteur auxiliaire (72) correspondant, le ou chaque circuit d'attaque de grille auxiliaire étant configuré pour injecter de manière sélective un courant dans la grille (40) de l'élément de commutation à semi-conducteur auxiliaire (72) correspondant.

3. Circuit de commutation à semi-conducteur (70) selon la revendication 1 ou la revendication 2 dans lequel le ou chaque élément de commutation à semi-conducteur auxiliaire (72) est ou inclut un élément de commutation en silicium.

4. Circuit de commutation à semi-conducteur (170) selon la revendication 1 incluant en outre un ou un circuit d'attaque de grille auxiliaire respectif agencé pour interconnecter le dispositif d'isolation de tension et une grille (40) du ou de chaque élément de commutation à semi-conducteur auxiliaire (172), le ou chaque circuit d'attaque de grille auxiliaire étant en outre connecté à une anode (36) de l'élément de commutation à semi-conducteur auxiliaire (172) correspondant, le ou chaque circuit d'attaque de grille auxiliaire étant configuré pour extraire de manière sélective un courant de la grille (40) de l'élément de commutation à semi-conducteur auxiliaire (172) correspondant.

5. Circuit de commutation à semi-conducteur (170) selon la revendication 1 ou la revendication 4 dans lequel le ou chaque élément de commutation à semi-conducteur auxiliaire (172) est ou inclut un élément de commutation en carbure de silicium, un élément de commutation en nitrure de gallium, un élément de commutation en diamant ou un élément de commutation fait d'un matériau à large bande interdite.

6. Circuit de commutation à semi-conducteur (70, 170) selon une quelconque revendication précédente dans lequel le ou chaque élément de commutation à semi-conducteur auxiliaire (72, 172) est ou inclut un thyristor.

7. Circuit de commutation à semi-conducteur (70, 170) selon une quelconque revendication précédente dans lequel l'unité de commande (30) est connectée fonctionnellement via un seul dispositif d'isolation de tension à chacun d'une pluralité d'éléments de commutation à semi-conducteur auxiliaires (72, 172) pour commander une commutation de chacun de la pluralité d'éléments de commutation à semi-conducteur auxiliaires (72, 172).

8. Circuit de commutation à semi-conducteur (70, 170) selon une quelconque revendication précédente dans lequel le ou chaque dispositif d'isolation de tension est ou inclut un transformateur (100).

9. Circuit de commutation à semi-conducteur (70, 170) selon une quelconque revendication précédente dans lequel le ou chaque élément de commutation à semi-conducteur auxiliaire (72, 172) et le ou chaque dispositif d'isolation de tension sont formés sur une carte de circuit imprimé, et éventuellement dans lequel le dispositif d'isolation de tension est formé comme un dispositif d'isolation de tension plan sur la carte de circuit imprimé.

10. Circuit de commutation à semi-conducteur (70, 170) selon une quelconque revendication précédente dans lequel l'unité de commande (30) est programmée pour désactiver de manière sélective le ou chaque élément de commutation à semi-conducteur auxiliaire (72, 172) lorsque le courant circulant à travers le ou chaque élément de commutation à semi-conducteur auxiliaire (72, 172) est égal à ou inférieur à un seuil de courant de sécurité.

11. Circuit de commutation à semi-conducteur (70, 170) selon une quelconque revendication précédente dans lequel la tension nominale de la branche de courant principale (74) est inférieure à la tension nominale de la branche de courant auxiliaire (76).

12. Circuit de commutation à semi-conducteur (70, 170) selon une quelconque revendication précédente dans lequel la branche de courant principale (74) inclut un seul élément de commutation à semi-conducteur principal (12) présentant des première et seconde bornes de connexion (14, 16) et la branche de courant auxiliaire (76) est connectée entre les première et seconde bornes de connexion (14, 16) selon lequel les branches de courant principale et auxiliaire (74, 76) définissent conjointement un ensemble de commutation à semi-conducteur.

13. Circuit de commutation à semi-conducteur (70, 170) selon la revendication 12 dans lequel la branche de courant auxiliaire (76) inclut un seul élément de commutation à semi-conducteur auxiliaire (172), ou dans lequel la branche de courant auxiliaire (76) inclut une pluralité d'éléments de commutation à semi-conducteur auxiliaires (72) connectés en série.

14. Circuit de commutation à semi-conducteur selon l'une quelconque des revendications 1 à 11 dans lequel la branche de courant principale inclut une chaîne principale d'éléments de commutation à semi-conducteur principaux connectés en série, la chaîne principale présentant une borne de connexion en amont au niveau d'une extrémité en amont de celle-ci et une borne de connexion en aval au niveau d'une extrémité en aval de celle-ci, la branche de courant auxiliaire est connectée entre les bornes de connexion en amont et en aval de la chaîne principale, et la branche de courant auxiliaire inclut une chaîne auxiliaire d'éléments de commutation à semi-conducteur auxiliaires (72) connectés en série.

15. Chaîne de commutation à semi-conducteur, pour une utilisation dans un convertisseur de puissance HVDC, comprenant une pluralité d'ensembles de commutation à semi-conducteur connectés en série selon la revendication 12 ou la revendication 13.
